# EUROPEAN PATENT SPECIFICATION

(11) **EP 2 850 664 B1**
(45) Date of publication and mention of the grant of the patent: **19.06.2019**
(21) Application number: 13724559.3
(22) Date of filing: 15.05.2013
(51) Int. Cl.: H01L 31/048, H01L 31/055, B32B 17/10, B32B 27/08, B32B 27/18, B32B 27/20

(54) **POLYMER SHEET**
POLYMERFOLIE
FEUILLE DE POLYMÈRE

(30) Priority: 16.05.2012 NL 2008839; 16.05.2012 NL 2008838; 16.05.2012 NL 2008837; 16.05.2012 NL 2008841; 16.05.2012 NL 2008840
(43) Date of publication of application: 25.03.2015
(73) Proprietor: Borealis AG, 1220 Vienna (AT)
(72) Inventor: DECLERCK, Johan Willy, B-1850 Grimbergen (BE); HASAERS, Koen, B-2960 Brecht (BE); PROOST, Kristof, B-2620 Hemiksem (BE)
(74) Representative: HGF Limited
(86) International application number: PCT/EP2013/060076
(87) International publication number: WO 2013/171275

(56) References cited:
- WO-A1-2008/110567
- DE-A1-102005 043 572
- DE-A1-102006 048 216
- DE-A1-102009 002 386
- DE-A1-102010 028 180
- US-A1- 2010 126 557
- BRYCE S RICHARDS ET AL: "Enhancing the Efficiency of Production CdS/CdTe PV Modules by Overcoming Poor Spectral Response at Short Wavelengths Via Luminescence Down-Shifting", CONFERENCE RECORD OF THE 2006 IEEE 4TH WORLD CONFERENCE ON PHOTOVOLTAIC ENERGY CONVERSION (IEEE CAT. NO.06CH37747), IEEE, 1 May 2006 (2006-05-01), pages 213-216, XP031007276, ISBN: 978-1-4244-0016-4
- KLAMPAFTIS E ET AL: "Enhancing the performance of solar cells via luminescent down-shifting of the incident spectrum: A review", SOLAR ENERGY MATERIALS AND SOLAR CELLS, ELSEVIER SCIENCE PUBLISHERS, AMSTERDAM, NL, vol. 93, no. 8, 1 August 2009 (2009-08-01) , pages 1182-1194, XP026139948, ISSN: 0927-0248, DOI: 10.1016/J.SOLMAT.2009.02.020 [retrieved on 2009-03-31] cited in the application

## Description

The invention relates to a polymer sheet comprising a luminescence downshifting compound. Such compounds have the property that they can at least partially absorb radiation having a certain wavelength and re-emit radiation at a longer wavelength than the wavelength of the absorbed radiation. The invention further relates to the various uses of the coextruded polymer sheet for glass elements and for photovoltaic cells and solar panels.

Such a polymer sheet is known from WO-A-2008/110567. This publication describes a polymer encapsulation sheet which is used to protect a photovoltaic cell and wherein the polymer encapsulation sheet comprises a luminescence downshifting compound. This publication does not disclose any working examples. The specification does disclose a large list of possible luminescence downshifting compounds of which many are organic compounds.

Many organic compounds have favourable properties regarding their efficiency to absorb radiation in a certain wavelength and re-emit radiation at a higher wavelength. A problem of applying such compounds is their stability. When a sheet comprising such organic compound is used in combination with a photovoltaic cell in a solar cell it is preferred that they remain stable during the life time of the solar cell.

The object of the present invention is to provide a polymer sheet comprising a luminescence downshifting compound, wherein the luminescence downshifting compound retains its downshifting capability over a longer period of time.

This object is achieved by the following polymer sheet. Polymer sheet comprising multiple coextruded polymer layers, wherein at least one of these layers comprise a luminescence downshifting compound for at least partially absorbing radiation having a certain wavelength and re-emitting radiation at a longer wavelength than the wavelength of the absorbed radiation.

Applicants found that by having separate polymer layers the stability of the luminescence downshifting compound as present in at least one layer can be improved.

The polymer sheet may have a first polymer layer comprising an UV stabilizer additive and another polymer layer comprises the luminescence downshifting compound. In this manner the luminescence downshifting compound may be protected against UV radiation and UV induced degradation, which typically affects the stability of the downshifting compounds and the polymers present in the polymer layers. This may result in a reduction of UV stabilisers, which in turn may not only increase the stability of the downshifting compounds used, but also reduce costs, and overall increase yield of harvested incandescent sunlight. Moreover, the use of different downshifting compounds in different layers permits to fine-tune the environment of the downshifting compounds, which may react with other downshifting compounds, particularly in the excited state, but also with chemicals present in the layers, such as for instance peroxides. Moreover, the use of coextruded polymer layers allows to fine tune the property of each layer, e.g. the copolymers, while providing them with either high adhesion through additional polymer layers and resistance against humidity. Preferably two or more layers of the polymer sheet comprise a luminescence downshifting compound. This allows that a layer comprising of luminescence downshifting compound or compounds which are less stable when exposed to radiation of a certain wavelength can be used in combination with a layer comprising a luminescence downshifting compound which can convert by means of a Stoke shift the harmful radiation to a less harmful radiation. The above layout results in a more stable polymer sheet.

The invention further provides that UV sensible polymers, like for example ethylene vinyl acetate (EVA) can be used in combination with no or considerably less UV stabilizer. In the prior art UV stabilizers are required to protect the polymer encapsulant sheet comprising EVA. The use of these stabilisers lowered the efficiency of a solar panel because the UV radiation is converted to heat by these UV stabilisers. By using a luminescent downshifting compound which can absorb radiation in the UV wavelength range and emit at a higher wavelength range the UV light is converted into radiation which is less harmful for the polymer and which can be effectively used to generate electricity by means of the photovoltaic effect.

Unless stated otherwise, all percentages, parts, ratios, etc., are by weight. When an amount, concentration, or other value or parameter is given as either a range, preferred range or a list of upper preferable values and lower preferable values, this is to be understood as specifically disclosing all ranges formed from any pair of any upper range limit or preferred value and any lower range limit or preferred value, regardless of whether ranges are separately disclosed. Where a range of numerical values is recited herein, unless otherwise stated, the range is intended to include the endpoints thereof, and all integers and fractions within the range. It is not intended that the scope of the invention be limited to the specific values recited when defining a range.

When the term "about" is used in describing a value or an end-point of a range, the disclosure should be understood to include the specific value or end- point referred to.

As used herein, the terms "comprises," "comprising," "includes," "including," "containing," "characterized by," "has," "having" or any other variation thereof, are intended to cover a non-exclusive inclusion. For example, a process, method, article, or apparatus that comprises a list of elements is not necessarily limited to only those elements but may include other elements not expressly listed or inherent to such process, method, article, or apparatus. Further, unless expressly stated to the contrary, "or" refers to an inclusive or and not to an exclusive or. The transitional phrase "consisting essentially of limits the scope of a claim to the specified materials or steps and those that do not materially affect the basic and novel characteristic(s) of the claimed invention.

Where applicants have defined an invention or a portion thereof with an open-ended term such as "comprising," it should be readily understood that unless otherwise stated the description should be interpreted to also describe such an invention using the term "consisting essentially of".

Use of "a" or "an" are employed to describe elements and components of the invention. This is merely for convenience and to give a general sense of the invention. This description should be read to include one or at least one and the singular also includes the plural unless it is obvious that it is meant otherwise.

In describing certain polymers it should be understood that sometimes applicants are referring to the polymers by the monomers used to produce them or the amounts of the monomers used to produce the polymers. While such a description may not include the specific nomenclature used to describe the final polymer or may not contain product-by-process terminology, any such reference to monomers and amounts should be interpreted to mean that the polymer comprises those monomers (i.e. copolymerized units of those monomers) or that amount of the monomers, and the corresponding polymers and compositions thereof.

In describing and/or claiming this invention, the term "copolymer" is used to refer to polymers formed by copolymerization of two or more monomers. Such copolymers include dipolymers, terpolymers or higher order copolymers.

The "melt flow index", further referred to as MFI herein, is a measure of the ease of flow of the melt of a thermoplastic polymer. It is defined as the mass of polymer, in grams, flowing in ten minutes through a capillary of a specific diameter and length by a pressure applied via prescribed alternative gravimetric weights for alternative prescribed temperatures, and is determined according to ASTM D1238.

It should be noted that where a polymer is formulated with a crosslinking mechanism that is initiated above a certain temperature, e.g. EVA copolymers and peroxides, the rheology values employed herein refer to materials that are not, or only partially cross-linked. Once the crosslinking has been complete, e.g. in a photovoltaic module lamination process, the polymers that have cross-linked are no longer considered as thermoplastic materials. Therefore, in so far as the specification refers to photovoltaic modules after lamination, the described properties refer to the polymers prior to the lamination process, also including the cross-linked polymers.

The term melting point as referred to herein refers to the transition from a crystalline or semi-crystalline phase to a solid amorphous phase, also known as the crystalline melting temperature. The melting point of a polymer may be advantageously be determined by DSC. In the case of a block co-polymer, the term melting point herein refers to the temperature at which the higher melting block component will pass its glass transition temperature, thereby allowing the polymer to melt and flow. The "extrusion temperature" refers to the temperature to which a polymer material is heated during extrusion, by means of a heated extruder and/or heated die.

Where to the melting temperature of a certain layer is referred, due to the fact that the layers are essentially composed of polymer materials with additives or optional other polymers only, this temperature will be largely determined by the melting temperature of the polymer material present in the layer. Accordingly, the melting temperature should be considered as the temperature of the polymer material present in the layer. The additives and/or optional polymers may be present in an amount of up to 25 wt%, based on the total weight of the main polymer in a layer, provided that the inclusion of such additives and/or optional polymers does not adversely affect the melt flow index.

The term "first polymer layer" refers to any layer of the polymer sheet that is present in the direction of the incandescent light. The layer may be the layer that is directly in contact with the glass or front sheet, or may be an intermediate layer. In this respect, the next layer refers to a layer further down in the direction of the incandescent light. The layers may be directly adjacent to each other, or may be separated by further intermediate layers.

Preferably a luminescence downshifting compound is present in a first polymer layer, which luminescence downshifting compound has the property that it can absorb more radiation at a lower wavelength that the luminescence downshifting compound present in a next layer. Thus this layer will comprise luminescence downshifting compound or compounds which will absorb radiation at a lower wavelength than the luminescence downshifting compound(s) in the remaining polymer layer(s). This is advantageous because many organic compounds are sensitive to especially the shorter wavelength radiation. By filtering said shorter wavelength radiation and re-emitting longer wavelength radiation a more stable polymer sheet is obtained. More preferably a first polymer layer, i.e. barrier layer, has the property that it can absorb at least partially UV radiation, suitably between 10 and 400 nm, and re-emit radiation at a higher wavelength. The luminescence downshifting compound(s) which absorb in this UV wavelength may be combined with traditional UV stabilizers. It is preferred to limit the use of such classic stabilizers because they transform the absorbed UV radiation into thermal energy rather than re-emitting the radiation at the longer wavelengths. Thus a more efficient polymer sheet is obtained when such UV stabilizers are omitted or used in a low concentration. The luminescence downshifting compound will then take over the protective function of the UV stabilizer.

The luminescence downshifting compound may be an organic or inorganic luminescent compound, which is capable of partially absorbing radiation having a certain wavelength and re-emitting radiation at a longer wavelength than the wavelength of the absorbed radiation. Such compounds are known and for example described by Efthymios Klampaftis, David Ross, Keith R. McIntosh, Bryce S. Richards, Enhancing the performance of a solar cell via luminescent down-shifting of incident spectrum, a review, Solar Energy Materials & Solar Cells 93 (2009) 1182-1194. At least some of the luminescence downshifting compounds are preferably organic compounds because the advantages of the invention apply especially to this group of compounds.

Suitable organic luminescence downshifting compound are for example laser dyes. The following compounds, of which some are also used as a laser dye, may find application as an organic luminescence downshifting compound: Rhodamine, for example 5-carboxytetramethylrhodamine, Rhodamine 6G, Rhodamine B, Rubrene, aluminium tris-([delta]-hydroxyquinoline (Alq3), N,N'-diphenyl-N,N'-bis-(3-methylphenyl)-1 ,1 '-biphenyl- 4-4'-diamine (TPD), bis-(8-hydroxyquinoline)-chlorogallium (Gaq2CI); a perylene carbonic acid or a derivative thereof; a naphthalene carbonic acid or a derivative thereof; a violanthrone or an iso-violanthrone or a derivative thereof. Examples of organic luminescence downshifting compound are quinine, fluorescien, sulforhodamine, ,5-Bis(5-tert-butyl-2-enzoxazolyl)thiophene, Nile Blue.

Other examples of suitable organic luminescence downshifting compounds are coumarin dyes, for example 7-Diethylaminocoumarin-3-carboxylic acid hydrazide (DCCH), 7-Diethylaminocoumarin-3-carboxylic acid succinimidyl ester, 7-Methoxycoumarin-3-carboxylic acid succinimidyl ester, 7-Hydroxycoumarin-3-carboxylic acid succinimidyl ester, 7-Diethylamino-3-((((2-iodoacetamido)ethyl)amino)carbonyl)coumarin (IDCC), 7-Diethylamino-3-((((2-maleimidyl)ethyl)amino)carbonyl)coumarin (MDCC), 7-Dimethylamino-4-methylcoumarin-3-isothiocyanate (DACITC), N-(7-Dimethylamino-4-methylcoumarin-3-yl)maleimide (DACM), N-(7-Dimethylamino-4-methylcoumarin-3-yl)iodoacetamide (DACIA), 7-Diethylamino-3-(4'-maleimidylphenyl)-4-methylcoumarin (CPM), 7-Diethylamino-3-((4'-(iodoacetyl)amino)phenyl)-4-methylcoumarin (DCIA), 7-Dimethylaminocoumarin-4-acetic acid (DMACA) and 7-Dimethylaminocoumarin-4-acetic acid succinimidyl ester (DMACASE).

Other examples of suitable organic luminescence downshifting compounds are perylene dyes, for example N, N'- Bis(2,6-diisopropylphenyl)perylene-3,4:9,10-tetracarbonic acid diimide, N,N'-Bis(2,6- dimethylphenyl)perylene-3,4:9,10-tetracarbonic acid diimide, N,N'-Bis(7- tridecyl)perylene-3,4:9,10-tetracarbonic acid diimide, N,N'-Bis(2,6-diisopropylphenyl)- 1,6,7,12-tetra(4-tert.-octylphenoxy)perylene-3,4:9,10-tetracarbonic acid diimide, N, N'- Bis(2,6-diisopropylphenyl)-1,6,7,12-tetraphenoxyperylene-3,4:9,10-tetracarbonic acid diimide, N,N'-Bis(2,6-diisopropylphenyl)-1,6- and -1,7-bis(4-tert- octylphenoxy)perylene-3,4:9,10-tetracarbonic acid diimide, N,N'-Bis(2,6- diisopropylphenyl)-1,6- and -1,7-bis(2,6-diisopropylphenoxy)-perylene-3,4:9,10- tetracarbonic acid diimide, N-(2,6-diisopropylphenyl)perylene-3,4-dicarbonic acid imide, N-(2,6-diisopropylphenyl)-9-phenoxyperylene-3,4-dicarbon acid imide, N-(2,6- diisopropylphenyl)-9-(2,6-diisopropylphenoxy)perylene-3,4-dicarbonic acid imide, N- (2,6-diisopropylphenyl)-9-cyanoperylene-3,4-dicarbonic acid imide, N-(7-tridecyl)-9- phen-oxyperylene-3,4-dicarbonic acid imide, perylene-3,9- and -3,10-dicarbonic acid diisobutyl-ester, 4,10-dicyanoperylene-3,9- and 4,9-dicyanoperylene-3,10-dicarbonic acid diisobutyl-ester and perylene-3,9- and -3,10-dicarbonic acid di(2,6- diisopropylphenyl)amide.

Perylene dyes usually absorb radiation in the wavelength region of 360 to 630 nm and re-emit between 470 to 750 nm. Besides perylene dyes, other fluorescent dyes having similar structures may be employed, such as dyes on the basis of violanthrones and/or iso-violanthrones, such as the structures disclosed in EP-A-073 007. As a preferred example of well suited compounds are alkoxylated violanthrones and/or iso-violanthrones, such as 6,15-didodecyloxyisoviolanthronedion-(9,18).

Other examples of suitable organic luminescence downshifting compounds are naphthalene type compounds. These dyes typically exhibit an absorption within the UV range at wavelengths of about 300 to 420 nm and exhibit an emission range at about 380 to 520 nm. Examples of naphthalene type compounds are the naphthalene carbonic acid derivatives, for example naphthalene 1,8:4,5-tetracarbonic acid diimides, and especially naphthalene-1,8-dicarbonic acid imides, most preferably 4,5-dialkoxynaphthalene-1,8-dicarbonic acid monoimides and 4-phenoxynaphthalene-1,8-dicarbonic acid monoimides. Other naphthalene type compounds are for example N-(2-ethylhexyl)-4,5-dimethoxynaphthalene-1,8-dicarbonic acid imide, N- (2,6-diisopropyl-phenyl)-4,5-dimethoxynaphthalene-1,8-dicarbonic acid imide, N-(7- tridecyl)-4,5-dimethoxy-naphthalene-1,8 dicarbonic acid imide, N-(2,6- diisopropylphenyl)-4,5-diphenoxynaphthalene-1,8-dicarbonic acid imide and N, N'- Bis(2,6-diisopropylphenyl)-1,8:4,5-naphthalene tetracarbonic acid diimide.

Other examples are Lumogen F Yellow 083, Lumogen F Orange 240, Lumogen F Red 305 and Lumogen F Violet 570 as obtainable from BASF.

For example the following organic luminescence downshifting compounds are capable of absorbing (excitation wavelength) at 300 to 360 nm and have an emission spectrum with a maximum around 365 up to 400 Nm: diphenyloxazole (2,5-diphenyloxazol 1,4-Di[2-(5-phenyloxazolyl)benzene, 4,4'-diphenylstilbene, 3,5,3'''',5''''-tetra-t-butyl-p-quinquephenyl. These compounds can be obtained for example from Synthon Chemicals GmbH and Luminescence Technology Corp.

For example the following organic luminescence downshifting compounds are capable of re-emitting the incoming radiation emission towards 400 - 460 nm: 2,5-thiopenediylbis(5-tert-butyl-1,3-benzoxale).

For example the following organic luminescence downshifting compounds are capable of re-emitting the incoming radiation emission towards 560nm: Hostasole 3G naphtalimide (Clariant), Lumogen F Yellow 083 (BASF), Rhodamine 110 (Lambdachrome 5700).

For example the following organic luminescence downshifting compounds are capable of re-emitting the incoming radiation emission towards 580-640nm: hostazole GG thioxanthene benzanthione (Clariant), - Lumogen F Red 305 (BASF), benzoic rhodamine 6G ethylaminoxanthene (Lambdachrome 5900),
For example the following organic luminescence downshifting compounds are capable of re-emitting the incoming radiation emission towards 640-680nm: cresyl purple diaminobenzole, Sublforhodamine B (Lambdachrome LC6200),
For example the following organic luminescence downshifting compounds are capable of re-emitting the incoming radiation emission towards 700-1000nm: Rhodamine 800 (Sigma), Pyridine 2 (Lambdachrome LC7600), DOTC, HITC (Lambdachrome LC7880), Styril 9 (Lambdachrome LC8400).

Suitable inorganic luminescent compounds are semiconducting quantum dot materials and nanoparticles comprising Sm³⁺, Cr³⁺, ZnSe, Eu²⁺ and Tb³⁺ and nanoparticles comprising ZnO; ZnS doped with Mg, Cu, and/or F; CdSe; CdS; Ti02; Zr³⁺, Zr⁴⁺; and/or Eu³⁺, Sm³⁺, or Tb³⁺ doped YPO₄. A common characteristic of these materials is that they are capable of exhibiting fluorescence. The nanoscale particles may be made by any suitable process, for example by the process as disclosed in US7384680. They may have an average diameter of less than 75 nm, more in particular they may have a size of between 3 and 50 nm as determined using Transmission electron microscopy (TEM). Possible Europium complexes suitable as luminescent compounds are [Eu(β-diketonate)3-(DPEPO)] as described by Omar Moudam et al, Chem. Commun., 2009, 6649-6651 by the Royal Society of Chemistry 2009.

Another example of a suitable inorganic luminescent compound are molecular sieves comprising oligo atomic metal clusters include clusters ranging from 1 to 100 atoms of the following metals (sub nanometer size), Si, Cu, Ag, Au, Ni, Pd, Pt, Rh, Co and Ir or alloys thereof such as Ag/Cu, Au/Ni etc. The molecular sieves are selected from the group consisting of zeolites, porous oxides, silicoaluminophosphates, aluminophosphates, gallophosphates, zincophophates, titanosilicates and aluminosilicates, or mixtures thereof. In a particular embodiment of the present invention the molecular sieves of present invention are selected from among large pore zeolites from the group consisting of MCM-22, ferrierite, faujastites X and Y. The molecular sieves in another embodiment of present invention are materials selected from the group consisting of zeolite 3 A, Zeolite 13X, Zeolite 4A, Zeolite 5 A and ZKF. Preferably the oligo atomic metal clusters are oligo atomic silver molecules containing 1 to 100 atoms. Illustrative examples of such molecular sieve based downshifting compounds are described in WO-A-2009006708.

The concentration of the luminescence downshifting compound in the polymer layer will depend on the chosen luminescence downshifting compound. Some compounds are more effective and will require a lower concentration in the polymer layer and some compounds will require a higher concentration because they are less efficient in absorbing and re-emitting radiation.

The polymer layer may comprise at least one luminescence downshifting compound. The polymer layer may comprise a single luminescence downshifting compound or more than one luminescence downshifting compound. If more than one luminescence downshifting compounds are present it is preferred that compounds are combined which absorb radiation at a different wavelength and re-emit radiation at a different longer wavelength. In this manner a so-called luminescence downshifting "cascade" may be obtained, wherein radiation re-emitted by one compound is absorbed by a next compound. Such a cascade is also referred to as a Photon-Absorption-Emitting Chain (PAEC).

More preferably the polymer sheet comprises the following coextruded polymer layers:
a first polymer layer (a) comprises a luminescence downshifting compound for absorbing radiation at between 280 to 400 nm and re-emitting radiation at between 400 to 550 nm,
another polymer layer (b) comprises a luminescence downshifting compound for absorbing radiation at between 360 to 470 nm and re-emitting radiation at between 410 to 670 nm, and
another polymer layer (c) comprises a luminescence downshifting compound for absorbing radiation at between 360 to 570 nm and re-emitting radiation at between 410 to 750 nm.

One or more luminescence downshifting compounds may be present in one of the above layers. Additional layers may be present in the polymer sheet, wherein the additional layers may also comprise luminescence downshifting compounds or other additives. Preferably, each layer only comprises luminescence downshifting compounds that can convert a certain wavelength range of light to a longer wavelength range, and not a cascade of wavelengths; preferably only a single compound or family of compounds.

Examples of suitable luminescence downshifting compounds for layer (a) are 2,5- diphenyloxazol (PPO diphenyloxazole), 4,4'-Diphenylstilbene (DPS), 1,4-Di[2-(5-phenyloxazolyl)benzene (POPOP), 3,5,3"",5""-Tetra-t-butyl-p-quinquephenyl (QUI P-quinqaphenyl), 1,8-ANS (1-Anilinonaphthalene-8-sulfonic acid), 1-Anilinonaphthalene-8-sulfonic acid (1,8-ANS), 6,8-Difluoro-7-hydroxy-4-methylcoumarin pH 9.0, 7-Amino-4-methylcoumarin pH 7.0, 7-Hydroxy-4-methylcoumarin, 7-Hydroxy-4-methylcoumarin pH 9.0, Alexa 350, BFP (Blue Fluorescent Protein), Cascade Yellow, Cascade Yellow antibody conjugate pH 8.0, Coumarin, Dansyl Cadaverine, Dansyl Cadaverine, MeOH, DAPI, DAPI-DNA, Dapoxyl (2-aminoethyl) sulphonamide, DyLight 350, Fura-2 Ca2+, Fura-2, high Ca, Fura-2, no Ca, Hoechst 33258, Hoechst 33258-DNA, Hoechst 33342, Indo-1, Ca free, LysoSensor Yellow pH 3.0, LysoSensor Yellow pH 9.0, Marina Blue, Sapphire, and/or SBFI-Na+ .

Examples of suitable luminescence downshifting compounds for layer (b) are: 7-Diethylaminocoumarin-3-carboxylic acid hydrazide (DCCH), 7-Diethylaminocoumarin-3-carboxylic acid succinimidyl ester, 7-Methoxycoumarin-3-carboxylic acid succinimidyl ester, 7-Hydroxycoumarin-3-carboxylic acid succinimidyl ester, 7-Diethylamino-3-((((2-iodoacetamido)ethyl)amino)carbonyl)coumarin (IDCC), 7-Diethylamino-3-((((2-maleimidyl)ethyl)amino)carbonyl)coumarin (MDCC), 7-Dimethylamino-4-methylcoumarin-3-isothiocyanate (DACITC), N-(7-Dimethylamino-4-methylcoumarin-3-yl)maleimide (DACM), N-(7-Dimethylamino-4-methylcoumarin-3-yl)iodoacetamide (DACIA), 7-Diethylamino-3-(4'-maleimidylphenyl)-4-methylcoumarin (CPM), 7-Diethylamino-3-((4'-(iodoacetyl)amino)phenyl)-4-methylcoumarin (DCIA), 7-Dimethylaminocoumarin-4-acetic acid (DMACA), 7-Dimethylaminocoumarin-4-acetic acid succinimidyl ester (DMACASE), Acridine Orange, Alexa 430, Alexa Fluor 430 antibody conjugate pH 7.2, Auramine O, Di-8 ANEPPS, Di-8-ANEPPS-lipid, FM 1-43, FM 1-43 lipid, Fura Red Ca2+, Fura Red, high Ca, Fura Red, low Ca, Lucifer Yellow and/or CH, SYPRO Ruby (CAS 260546-55-2).

Examples of suitable luminescence downshifting compounds for layer (c) are the above compounds illustrated for layer (b) and Rhodamine 110, Rhodamine 6G ethylaminoxanthene benzoique (obtainable from Lambdachrome), Alexa Fluor 647 R-phycoerythrin streptavidin pH 7.2, Ethidium Bromide, Ethidium homodimer, Ethidium homodimer-1-DNA, FM 4-64, FM 4-64, 2% CHAPS, Nile Red-lipid and/or Propidium Iodide.

An example of another possible cascade may comprise a first luminescence downshifting compound with an absorption range located at approximately 280 nm tot 365 nm and with an emission range located at approximately 380 nm to 430 nm. An example of a suitable luminescence downshifting compound is 3,5,3"",5""-tetra-t-butyl-p-quinquephenyl, known to have a maximum absorption at approximately 310 nm and a maximum emission at approximately 390 nm. This luminescence downshifting compound may be added at a concentration of for example around 33% of the total content of luminescence downshifting compounds in the polymer layer. A second luminescence downshifting compound with an absorption range located at approximately 335 to 450 nm and with an emission range located at approximately 410 up to 550 nm. An example of a suitable luminescence downshifting compound is 2,3,5,6-1H,4H- tetrahydroquinolizino-[9,9a,1-gh]-coumarin, with a maximum excitation wavelength at approximately 396 nm and a maximum emission wavelength at approximately 490 nm in a concentration of for example around 33% of the total content of luminescence downshifting compounds in the polymer layer. A third luminescence downshifting compound of the cascade may have an absorption range located at approximately 450 nm tot 550 nm and with an emission range located at 560 nm till 700 nm. An example of a suitable luminescence downshifting compound is 1-amino-2-methylantraquinone with a maximum absorption around 450 nm and a maximum emission at approximately 600 nm in a concentration of for example around 33% of the total content of luminescence downshifting compounds in the polymer layer.

The total concentration of the down conversion blend in the polymer matrix depends on the thickness of the film as the efficient down conversion is function of the amount of molecules the incident light will encounter per volume. A polymer layer of approximately 400 to 450 microns may for example be doped with the constituting luminescence downshifting compounds in the range of 200 up to 1000 ppm. A suitable polymer layer of 450 microns with a good balance of UV blocking and transmission was for example obtained at a concentration of the constituting luminescence downshifting compounds of approximately 500 ppm in the final polymer layer.

The polymer material of the different polymer layers of the polymer sheet may be ethylene vinyl acetate (EVA), polyvinylbutyral (PVB), polymethylmethacrylate(PMMA), alkylmethacrylate, alkylacrylate copolymers, such as for example polymethacrylate poly-n-butylacrylate (PMMA-PnBA), elastomers, e.g. SEBS, SEPS, SIPS, polyurethanes, functionalized polyolefines, lonomers, thermoplastic polydimethylsiloxane copolymers, or mixtures thereof. Preferably ethylene vinyl acetate (EVA), polyvinylbutyral (PVB), silicone, polymethylmethacrylate(PMMA), alkylacrylate copolymers, such as for example polymethacrylate poly-n-butylacrylate (PMMA-PnBA) are used. Preferably, at least one of the polymer layers is composed of an ethylene vinyl acetate polymer. These polymers are advantageous because they provide a suitable matrix for the luminescence downshifting compound or compounds. Furthermore the resulting sheet can be easily used in a thermal lamination process to make an end product comprising the polymer sheet. Other possible polymers are polymethylemethacrylate (PMMA), polyvinylbutyral (PVB), polyvinylidene fluoride (PVDF), polycarbonate (PC), polyurethane, silicone or mixtures thereof.

A further preferred polymer is Ethylene-vinyl alcohol copolymers, hereinafter referred to as "EVOH", which is known to provide strong oxygen barrier properties, transparency, oil resistance, antistatic properties, mechanical strength and the like, and thus have been widely used as various types of wrapping material and the like such as films and sheets. EVOH may advantageously be prepared by saponification of ethylene vinyl acetate copolymer.

Preferably the polymer is an ethylene/vinyl acetate copolymer (EVA) comprising copolymerized units of ethylene and vinyl acetate. The EVA may have a melt flow rate (MFR) in the range of from 0.1 to 1000 g/10 minutes, preferably of from 0.3 to 300 g/10 minutes, yet more preferably of from 0.5 to 50 g/10 minutes, as determined in accordance with ASTM D1238 at 190°C and 2.16 kg.

Preferably the ethylene vinyl acetate has an acetate content of between 12 and 45 wt%, more preferably between 20 and 40 wt% and even more preferably between 25% up to 40 wt%.

The EVA may be a single EVA or a mixture of two or more different EVA polymers. By different EVA polymers is meant that the copolymers having different comonomer ratios, and/or the weight average molecular weight and/or molecular weight distribution may differ. Accordingly the EVA polymer may also comprise polymers that have the same comonomer ratios, but different MFR due to having different molecular weight distribution.

In a preferred embodiment, the EVA polymers advantageously comprise further monomers other than ethylene and vinyl acetate, such as alkyl acrylates, whereby the alkyl moiety of the alkyl acrylate may contain 1 -6 or 1 -4 carbon atoms, and may be selected from methyl groups, ethyl groups, and branched or unbranched propyl, butyl, pentyl, and hexyl groups.

The EVA copolymers used herein may also contain other additives known within the art. The additives may include processing aids, flow enhancing additives, lubricants, dyes, flame retardants, impact modifiers, nucleating agents, anti-blocking agents such as silica, thermal stabilizers, dispersants, surfactants, chelating agents, coupling agents, reinforcement additives, such as glass fibre, fillers and the like.

The polymer layers comprising of ethylene-vinyl acetate copolymer preferably comprise of one or more organic peroxides, which enables to crosslink the ethylene-vinyl acetate copolymer, thereby increasing the adhesion strength, humidity resistance and penetration resistance, while maintaining a high transparency, if so desired. Any organic peroxides that are decomposed at a temperature of at least 110°C to generate radicals may advantageously be employed as the above-mentioned organic peroxide. The organic peroxide or combination of peroxides are generally selected in the consideration of film-forming temperature, conditions for preparing the composition, curing (bonding) temperature, heat resistance of body to be bonded and storage stability. According to a preferred embodiment of the subject invention, the peroxide is chosen such that it does essentially not decompose at the resin processing temperature, in particular during coextrusion and/or a further extrusion and pelletizing step, while is only activated at the solar cell formation temperature or lamination temperature. "Essentially not decomposing" according to the present invention refers to a half-life of at least 0.1 to 1 hours at the coextrusion temperature. Examples of the organic peroxides include 2,5-dimethylhexane-2,5-dihydroperoxide, 2,5-dimethyl-2,5-di(tert-butylperoxy)hexane, 3-di-tert-butylperoxide, dicumyl peroxide, 2,5-dimethyl-2,5-di(2-ethylhaxanoylperoxy)hexane, 2,5-dimethyl-2,5-di(tert-butylperoxy)hexane, tert-butylcumylperoxide, [alpha],[alpha]'-bis(tert-butylperoxyisopropyl)benzene, [alpha],[alpha]'-bis(tert-butylperoxy)diisopropylbenzene, n-butyl-4,4-bis(tert-butylperoxy)butane, 2,2-bis(tert-butylperoxy)butane, 1,1-bis(tert-butylperoxy)cyclohexane, 1,1-bis(tert-butylperoxy)-3,3,5-trimethylcyclohexane, tert-butylperoxybenzoate, benzoyl peroxide, and 1,1-di (tert-hexylperoxy)-3,3,5-trimethylcyclohexane. Of these, 2,5-dimethyl-2,5-di(2-ethylhexanoylperoxy)hexane, and 1,1-di (tert-hexylperoxy)-3,3,5-trimethylcyclohexane are particularly preferred. The content of the organic peroxide in the film layers is preferably in the range of 0.1 to 5 parts by weight, more preferably in the range of 0.2 to 1.8 parts by weight based on 100 parts by weight of ethylene-vinyl acetate copolymer.

Preferably the polymer layer comprises two or suitably 2-12 coextruded polymer layers, wherein two or more polymer layers comprise a luminescence downshifting compound. Such a multi-layer is made by simultaneously coextruding and orienting a film composed of the different layers.

The polymers used for the different layers may be different provided that the difference in Melt Flow Index of the polymers at the conditions of coextruding is less than 4 points and preferably less than 2 points. If different polymers having a different MFI at for example a standard condition are combined it is preferred to adjust the extrusion temperature of the different polymers such that the MFI at the conditions of coextruding are within the above described ranges. A polymer sheet having at least 3 layers will comprise of two outer layers and at least one inner layer. Preferably the melt flow index of the inner polymer layer at the extrusion temperature of inner polymer layer is equal to or in the range of from -2 to plus 2 MFI points to the MFI of the outer layers at the extrusion temperature or temperatures of the outer layers. Preferably the MFI of an inner polymer layer differs in a range of from 0.5 to 10 from the MFI of an outer polymer layer or both outer polymer layers at a temperature TL, wherein TL is the lamination temperature of a vacuum lamination process to prepare a solar panels comprising the polymer sheet according to the invention. Typical temperatures for the lamination are in the range of from 135 to 165 °C, preferably 145 to 155 °C.

Preferably one or both outer polymer layers have a melting point T1 which at least 10 °C below the melting point T2 of at least one of the inner polymer layers. Preferably, the melting point T1 is between 10 and 50 °C lower than the melting point T2, more preferably between 10 and 35 °C lower. Applicants found that shrinkage of the polymer sheet at lamination conditions can be significantly lower when such a high melting inner polymer layer is part of the polymer sheet. More preferably the MFI of both outer layers are higher than the MFI of at least one inner polymer layer as measured at the lamination temperature. Applicants found that such a polymer sheet may advantageously be used to make a solar panel in a thermal lamination process wherein the photovoltaic cells are sufficiently encapsulated by the outer layer of the polymer sheet while at the same time no or very reduced shrinkage occurs. This is advantageous because less or no annealing of the polymer sheet will then be required when preparing the polymer sheet. Shrinkage of the polymer sheet is to be avoided or reduced in order to avoid that the sheet damages the vulnerable silicon photovoltaic cells when laminating a solar panel. Applicants found that for a preferred combination of polymer materials for the layers of the polymer sheet the lamination temperature as applied, when the polymer sheet is combined with for example a photovoltaic cell, is higher than the temperature at which the inner layer is extruded, when preparing the polymer sheet, and wherein the temperature at which the inner layer is extruded, when preparing the polymer sheet, is in turn higher than the temperature at which at least one of the outer layers is extruded, when preparing the polymer sheet.

Suitably the above described inner polymer layer comprises of an optionally hydrogenated polystyrene block copolymer with butadiene, isoprene and/or butylenes/ethylene copolymers, for example SIS, SBS and/or SEBS; a polymethacrylate polyacrylate block copolymer, a polyolefin, a polyolefine copolymer or terpolymer, or an olefin copolymer or terpolymer, with copolymerizable functionalised monomers such as methacyrylic acid (ionomer). Examples are a poly methyl metacrylate n-butylacrylate block copolymer, as disclosed in WO2012057079, and commercially available as "Kurarity" from Kuraray Corp. A further example comprises a polyolefin, preferably a polyethylene or polypropylene, such as an LDPE type. Polyolefins, such as polyethylene and polypropylene suitable for the inner sub layer include high density polyethylene, medium density polyethylene, low density polyethylene, linear low density polyethylene, metallocene-derived low density polyethylene homopolypropylene, and polypropylene co-polymer.

The polymer composition of at least one or more layer(s) comprising the luminescence downshifting compound is preferably selected such that the light absorbing and emitting activity of the luminescence downshifting compound is not affected under accelerated weathering conditions according to ISO 4892 part 2, Method A, Cycle 2 for at least 100 hours. At least one of the polymer layers may advantageously have high moisture and/or gas barrier properties, e.g. as those provided by polyolefin films, and/or ethylene vinyl alcohol copolymers (EVOH). Combinations thereof may also be applied, depending on the desired properties.

Coextrusion is well known process to the skilled person and utilizes two or more extruders to melt and deliver a steady volumetric throughput of different viscous polymers to a single extrusion head (die) which will extrude the materials in the desired sheet like form. The layer thicknesses may be controlled by the relative speeds and sizes of the individual extruders delivering the polymeric materials.

It may be preferable to add additives to at least one of the outer layers of the polymer sheet which improve the adhesive strength of the polymer sheet to glass. In some applications the polymer sheet is applied directly onto a glass layer and a good adhesive property of the polymer sheet will then be required. If the polymer sheet is applied between two layers of glass it is preferred that both outer layers of the polymer sheet have good adhesive strengths to glass. Possible additives are silane coupling agents that may be added to the EVA copolymer to improve its adhesive strength with the glass layer or layers. Useful illustrative silane coupling agents include [gamma]-chloropropylmethoxysilane, vinylmethoxysilane, vinyltriethoxysilane, vinyltris([beta]- methoxyethoxy)silane,[gamma]-vinylbenzylpropylmethoxysilane, N-[beta]-(N- vinylbenzylaminoethyl)-[gamma]-aminopropyltrimethoxysilane, [gamma]-methacryloxypropyltrimethoxysilane, vinyltriacetoxysilane, Y-glycidoxypropyltrimethoxysilane, [gamma]-glycidoxypropyltriethoxysilane, [beta]-(3,4-epoxycyclohexyl)ethylthmethoxysilane, methacryloxypropyltriethoxysilane, vinylthchlorosilane, methacryloxypropyltrimethoxysilane, [gamma]-mercapto-propylmethoxysilane, [gamma]-aminopropyltriethoxysilane, N-[beta]-(aminoethyl)-[gamma]- aminopropyltrinethoxysilane, and/or mixtures of two or more thereof.

The silane coupling agents are preferably incorporated in the relevant polymer layer. For a polymer layer comprising of an ethylene vinyl acetate polymer the silane coupling agents are preferably incorporated at a level of 0.01 to about 5 wt%, or more preferably 0.05 to about 1 wt%, based on the total weight of the polymer.

The polymer sheet according to the invention is especially suited to convert the shorter wavelength radiation of sunlight to longer wavelength radiation having a wavelength range in which photovoltaic cells convert radiation into electricity more effectively. The invention is thus also directed to the use of the polymer sheet according to the invention for enhancing the performance of a photovoltaic cell by luminescent down-shifting of sunlight.

The polymer sheet according to the invention is preferably used as part of a solar panel comprising a photovoltaic cell. The photovoltaic cell may comprise at least one of the following materials: CdS, CdTe; Si, preferably p-doped Si or crystalline Si or amorphous Si or multicrystalline Si; InP; GaAs; Cu2S; Copper Indium Gallium Diselenide (CIGS). A solar panel may be prepared by stacking the different layers of glass, the polymer sheet according to the invention, the photovoltaic cell, additional encapsulant layer or layers and a backsheet layer and subjecting the formed stack to a lamination process step.

The optimal photovoltaic performance of a PV cell will be different for each type of PV cell and thus the degree of conversion required by the luminescent downconversion compounds may be different for different PV cells. Preferably the polymer layer comprising a luminescence downshifting compound of the polymer sheet which is most spaced away from the photovoltaic cell comprises a luminescence downshifting compound which has the property that it can absorb at least partially UV radiation (between 10 and 400 nm) and re-emit radiation at a higher wavelength.

The invention is also directed to a solar panel comprising the polymer sheet according to the invention and a photovoltaic cell. Preferably the polymer layer comprising a luminescence downshifting compound which is most spaced away from the photovoltaic cell comprises a luminescence downshifting compound for at least partially absorbing UV radiation and re-emitting radiation at a higher wavelength. Such a solar panel preferably has a layer sequence of a glass layer, the polymer sheet, a photovoltaic cell, an encapsulant layer and a back sheet. The encapsulant layer may be a state of the art encapsulant layer, for example a thermally curable polymer layers such as the earlier described EVA copolymer. The photovoltaic cell is suitably a crystalline silicon cell, CdTe, αSi, micromorph Si or Tandem junction αSi. The backsheet may be a hard polymer, such as for example a layer of PET or more preferably a glass layer. When thin film photovoltaic cells are used, for example CIGS and CIS type cells, the solar cell panel may comprise a glass top layer, the polymer sheet of the present invention, the thin film photovoltaic cell and a rigid support, such as for example glass.

Preferably the glass layer facing the incoming radiation has a thickness of between 1.5 and 4 mm and wherein the glass layer used as back sheet has a thickness of 1.5 and 4 mm and wherein the total thickness of the solar panel is less than 9 mm. The glass layer may for example be float glass or roll glass. The glass may optionally be thermally treated. Suitable thermally toughened thin glass sheets glass layers having such a thickness may be obtained from for example Saint Gobain Glass. The glass layer may sodium free glass, for example alumina silicate or borosilicate glass. For large volume production it is preferred to use a soda lime glass or borosilicate glass. The soda lime glass may comprise between 67-75% by weight SiO₂, between 10-20% by weight; Na₂O, between 5-15% by weight CaO, between 0-7% by weight MgO, between 0-5% by weight Al₂O₃;between 0-5% by weight K₂O, between 0-1.5% by weight Li₂O and between 0-1 %, by weight BaO. Such a glass will suitably have a transparency of higher than 90%. Suitably the glass has been subjected to a thermally toughening treatment.

The surface of the glass layer, especially the surface not facing the polymer sheet and facing the incoming radiation is coated with a suitable anti-reflection layer. The anti-reflective layer will limit the radiation which reflects at the glass surface. Limiting this reflection will increase the radiation passing the glass element which will as a result enhance the efficiency of the glass element to transmit radiation. Preferably the coating is applied to one glass layer, namely the glass layer which will in use face the incoming radiation, i.e. sunlight. The side facing the polymer sheet may optionally be provided with such a coating. A suitable anti-reflection coating will comprise of a layer of porous silica. The porous silica may be applied by a sol-gel process as for example described in US-B-7767253. The porous silica may comprise of solid silica particles present in a silica based binder. Such a coating is obtainable from DSM, The Netherlands, as Khepri Coat™. Processes to prepare glass layers having an anti-reflective coating are for example described in WO-A-2004104113 and WO-A-2010100285.

The glass surface facing the incoming radiation may also have an embossed structure to capture incoming radiation more effectively, as for example described in WO2005111670.

A solar panel as described above may be obtained by subjecting a stack comprising the following layers:
a glass layer (a),
a polymer sheet according to the invention (b),
a layer (c) comprising a photovoltaic cell,
a polymer encapsulant layer (d); and
a glass layer (e), to a thermal lamination at an elevated lamination temperature.

The lamination temperature may be between 115 and 175 °C and wherein the environment of the stack preferably has a pressure of less than 30 mBar, more preferably less than 1 mBar. In this process the stack is preferably present in a vacuum laminator and pressure bonded under conversion heating at a temperature in the range of from of 115 to 175°C, preferably 140 to 165°C, most preferably from 145 to 155°C. The laminate is preferably also subjected to degassing. The compression lamination pressure preferably is in the range of from of 0.1 to 1.5 kg/cm2. The lamination time typically is in the range of from 5 to 25 minutes. This heating enables for example the ethylene-vinyl acetate copolymer contained in the polymer sheet according to the invention and in the encapsulant layer to crosslink, whereby the photovoltaic cell, the polymer sheet and the encapsulant layer are strongly adhered to seal the photovoltaic cell and obtain the solar panel.

Applicants have found that when the MFI at the lamination temperature is different between outer sub layers and an inner layer even less shrinkage occurs. The invention is thus also directed to a preferred process of manufacture of the solar panel wherein the first and/or second polymer encapsulant layer is comprised of 3 or more multiple coextruded thermoplastic polymer sub-layers comprising two outer sub-layers and at least one inner sub-layer and wherein at the lamination temperature the MFI of the inner sub-layer differs in a range of from 0.5 to 10 points from the MFI of one or both of the outer sub-layers of the same layer.

Even more preferred process of manufacture is wherein the polymer sheet according to the invention is comprised of 3 or more multiple coextruded thermoplastic polymer sub-layers comprising two outer sub-layers and at least one inner sub-layer, wherein the multiple coextruded thermoplastic polymer layer is obtained by co-extrusion of different polymer materials which polymer materials are extruded at an extrusion temperature for each sub-layer so chosen that the largest difference in melt flow index of the polymers of the sub-layers at the extrusion temperature as applied for each sub-layer is lower than 5 MFI points, preferably lower than 3 MFI points, wherein the lamination temperature TL is higher than the extrusion temperature TC of an inner sub-layer and wherein the temperature TC is higher than the extrusion temperature TA of an outer sub-layer and/or TB of the other outer sub-layer.

The invention is also directed to a glass element. Glass elements are known for instance as covers for greenhouses. Sunlight easily passes the glass roof of such a greenhouse and photosynthesis of at least one plant species takes place. But glass elements are also being used as a transparent and protective layer of a solar panel.

The element may advantageously be employed to improve the efficiency of a light induced process such as but not limited to photosynthesis or power generation by the means of the photovoltaic effect. This aim is achieved by the following glass element, comprising two layers of glass, wherein a transparent polymer layer is present between the two layers of glass and wherein the polymer layer comprises at least one luminescence downshifting compound adapted for at least partially absorbing radiation having a certain wavelength and re-emitting radiation at a longer wavelength than the wavelength of the absorbed radiation.

Applicants found that when such a glass element is used as roof of a greenhouse the photosynthesis of at least one plant species can be enhanced because part of the shorter wavelength radiation is downshifted to a wavelength more suited for photosynthesis. Thus more photosynthesis can take place at given sunlight intensity. Applicants also found that when such glass element is used as cover sheet of a photovoltaic system more power can be generated at a given sunlight intensity.

Another advantage is that the glass layers avoid water ingress towards the polymer layer. Small amounts of water may negatively affect the stability of certain luminescence downshifting compounds, especially the organic luminescence downshifting compound. By using two layers of glass the luminescence downshifting compound as present in the polymer layer is effectively protected against water induced degradation. Further advantages will be discussed when describing the preferred uses below.

The glass element may be used for various applications wherein it is desired to filter radiation having a short wavelength and being transparent for radiation having a longer wavelength. A preferred use is wherein the glass element is used for changing the properties of sun light and wherein the thus obtained adapted sunlight as it has passed the glass element is used to grow plants or more generally wherein the adapted sunlight is used in a photosynthesis process. The invention is also directed to a building, like a green house, having a roof comprising a glass element according to the invention.

Another preferred use of the glass element is for changing the properties of sun light in a process of generating electricity. More preferably the process for generating electricity involves a photovoltaic cell (photovoltaic cell) which is capable of generating an electrical current using the adapted sun light. The photovoltaic cell is suitably positioned near of adjacent the glass element, suitably fixed to the glass element. Many photovoltaic cells have a poor spectral response to the shorter wavelengths, for example the radiation in the UV range. By absorbing radiation in the shorter wavelength area and re-emitting at the longer wavelength, optionally by means of a cascade as described above, it is possible to effectively make use of the energy comprised in the radiation having these shorter wavelength in the form of radiation having a higher wavelength at which the photovoltaic cell have their optimal photovoltaic performance. The optimal photovoltaic performance of a photovoltaic cell will be different for each type of photovoltaic cell. Indeed, different Internal Quantum Efficiency (IQE) plots are obtained over a wavelength range from 300 up to 1100 for cSi screen printed cells, depending on the type of cSi cell, the surface texture and cell surface treatment.

The glass layer prior to, and after the polymer layer comprising the luminescence downshifting compound and the photovoltaic cell will provide a barrier against compounds being transported from the polymer layer to the photovoltaic cell or from the photovoltaic cell to the polymer layer. A solar panel will be used for many years and during its lifetime luminescence downshifting compounds or other additives present in the polymer layer may decompose into fragments which may be harmful for the photovoltaic cell. Examples of such elements or compounds are amines, chlorides, sodium and sulphur containing compounds. The glass layer, when used as front sheet, will avoid that such compounds can migrate and reach the photovoltaic cell and thus provide a longer lifetime of the photovoltaic cell itself. The glass element thus provides the use of organic luminescence downshifting compounds, which may decompose into these harmful fragments, in combination with a photovoltaic cell. Furthermore compounds may migrate from the photovoltaic cell towards the polymer layer which may result in degradation of the polymer and/or the luminescence downshifting compounds. The glass layer effectively avoids such migration. In this way, the increased use of incandescent light for various photovoltaic cells will be also useable for existing production lines, by simply replacing the front sheet.

The photovoltaic cell may comprise at least one of the following materials: CdS, CdTe; Si, preferably p-doped Si or crystalline Si or amorphous Si or multicrystalline Si or multiple junction Si; InP; GaAs; Cu2S; Copper Indium Gallium Diselenide (CIGS). A solar panel may be prepared by stacking the different layers of the glass element and the photovoltaic cell, additional encapsulant layer or layers and a backsheet layer and subjecting the formed stack to a lamination process step. In this manner the glass element is formed simultaneously with the formation of the solar cell itself.

A preferred photovoltaic cell is a thin film cadmium telluride (CdTe) photovoltaic cell. This type of photovoltaic cell shows an optimal photovoltaic effect at a wavelength of between 500 and 800 nm. By combining such a PV cell with the glass element according to the invention it is found possible to more effectively make use of the lower wavelength radiation of sunlight. The one or more luminescence downshifting compounds present in the glass element will absorb the lower wavelength radiation and reemit at the above wavelength range at which the CdTe photovoltaic cell exhibits maximum IQE. Preferably a luminescence downshifting compound or compounds or a cascade of luminescence downshifting compounds will be present in the polymer layer of the glass element which will absorb radiation at a wavelength below 500 nm and reemit radiation at a wavelength between 500 and 800 nm. Preferably the earlier described luminescence downshifting cascade is present in the glass element.

The invention is thus also directed to a CdTe photovoltaic solar cell comprising the glass element according to the invention, (a) a transparent electrode layer, (b) an n-type semiconductor layer, (c) an absorber, cadmium telluride (CdTe), and (d) a back contact. Layers (a)-(d) are deposited sequentially on the glass element according the invention. The glass element preferably is provided with the above described anti reflective coating at one side and with the above layers at its opposite side. Preferably the glass layer provided with the anti-reflective coating is thicker than the glass layer facing the layers (a)-(d).

The transparent electrode layer (a) may for example be comprised of tin oxide (SnO2) or a doped tin oxide, for example fluorine-, zinc or cadmium doped tin oxide, indium-tin oxide (ITO), zinc oxide (ZnO), and cadmium stannate (Cd2SnO4). For example, the buffer layer 205 may be formed to a thickness of up to about 1.5 microns or about 0.8-1.5 microns and may include ZnO and SnO₂ in about a one to two (1:2) stoichiometric ratio. Preferably tin oxide is used.

The n-type semiconductor layer (b) may be CdS, SnO₂, CdO, ZnO, AnSe, GaN, In₂O₂, CdSnO, ZnS, CdZnS or other suitable n-type semiconductor material and preferably CdS. Layer (b) may be formed by chemical bath deposition or by sputtering and may have a thickness from about 0.01 to about 0.1 µm.

The cadmium telluride (CdTe) layer (c) may be applied by screen printing, spraying, close-spaced sublimation, electro-deposition, vapour transport deposition, sputtering, and evaporation.

The back contact layer may be any suitable conductive material and combinations thereof. For example, suitable materials include materials including, but not limited to, graphite, metallic silver, nickel, copper, aluminium, titanium, palladium, chrome, molybdenum alloys of metallic silver, nickel, copper, aluminium, titanium, palladium, chrome, and molybdenum and any combination thereof. Suitably the back contact layer (d) is a combination of graphite, nickel and aluminium alloys.

The layers (a)-(d) may be encapsulated by a further glass layer (e). Encapsulating glass layer (e) may be a rigid structure suitable for use with the CdTe photovoltaic cell. The encapsulating glass layer (e) may be the same material as the glass used in the glass element or may be different. In addition encapsulating glass layer (e) may include openings or structures to permit wiring and/or connection to the CdTe photovoltaic cell.

Applying the above layers to the glass element according to the invention to obtain the preferred CdTe photovoltaic solar cell may be performed by the numerous methods known in the art. Examples of such methods and variations in the different layers are described in US-A-2011/0308593, EP-A-2430648, US-A-2012073649, US-A-2011259424 and the like.

The glass element may also be combined with wafer-based photovoltaic cells based on monocrystalline silicon (c-Si), poly- or multi-crystalline silicon (poly-Si or mc-Si) and ribbon silicon. Preferably the solar cell comprising such a wafer-based PV cell will comprise the glass element according to the invention as front facing in use the incoming radiation, a polymer layer, a layer comprising a wafer-based PV cell and a back sheet layer.

The back sheet layer may be a multilayered film, typically comprising at least three layers which may be prepared from different polymeric materials.

The back sheet layer preferably comprises a so-called white reflector. The presence of a white reflector is advantageous because it will reflect radiation to the photovoltaic cell and thus improve the efficiency of the cell.

Possible backsheet layers comprise fluoropolymer layers. Instead of a fluoropolymer layer a second glass sheet may be provided at the back of the solar cell. This will provide a solar cell which has a glass front and backside. The glass layer for use as backside will preferably have a thickness of less than 3 mm. The glass layers may be as described above. The use of a glass front and backside is advantageous because it provides a structural strength to the panel such that no aluminium frame is necessary. The glass backside will also provide an absolute barrier towards water ingress and the like which is advantageous for extending the life time of the panel. The use of the glass layer will make it possible to avoid the use of a back sheet comprising a fluoropolymer.

The glass element according to the invention may be prepared by subjecting a stack of a first glass layer, the polymer layer and the second glass layer to a thermal lamination process. In such a process the polymer layer will become more fluid and connect the glass layers while any gas is forced away from the stack by applying a vacuum.

The following examples illustrate the invention:

### Comparative Example 1

A mono layer EVA foil was produced as follows: A commercially available ethlyene vinyl acetate copolymer with a 33% vinylactetate content and an MFI of approximately 45 g/10 min was employed. A commercially available fluorescent perylene dye absorbing light at a wavelength of 578 nm, and emitting at a wavelength of 613 nm, was blended with the EVA material, in a concentration of 0.05% by weight, in a manner as for instance disclosed in US-B-7727418.

The foil material further contained approximately 1% by weight of methacryloxypropyltrimethoxysilane as an adhesion promoter, and approximately 1% by weight of *tert*-Butylperoxy 2-ethylhexyl carbonate as peroxide cross-linking agent.

The material was blended homogeneously, and a thin plate of about 500 µm thickness was pressed at a temperature of 110°C of each blend.

The resulting plate was then laminated between two glasses using the following lamination protocol on a flat-bed vacuum laminator from Meier:
Temperature: 145°C; Vacuum time: 300 seconds; Pressure ramp up: 30 seconds and Press time: 400 seconds.

The two samples were then placed into a UV weathering chamber, and subjected to an accelerated aging test, employing the test cycle disclosed as ISO 4892 part 2, Method A, Cycle 2, Entitled "Plastics Methods of Exposure to Laboratory Light Sources - Xenon Arc Lamps".

After 50 hours of exposure, the sample showed discoloration. A UV/VIS spectrometry was taken, showing that the sample no longer exhibit absorption typical for the perylene dye.

### Example 1

A 3-layer co-extruded foil was produced with the following composition:
Layer 1: EVA + 1% methacryloxypropyltrimethoxysilane 1% by weight of *tert-*Butylperoxy 2-ethylhexyl at a thickness of 200 µm, and further comprising a commercial light stabilization package containing a combination of HALS and antioxidants, to protect the EVA polymer matrix from degradation.
Layer 2: PMMA + 0.05% perylene dye, at a thickness of 50 µm.
Layer 3: EVA + 1% methacryloxypropyltrimethoxysilane 1% by weight of *tert-*Butylperoxy 2-ethylhexyl, at a thickness of 200 µm, further comprising the light stabilisation package of Layer 1.

The resulting sample showed a high stability of the perylene dye after 500 hours of UV weathering, while also typical encapsulation properties, such as adhesion, cross-linking, flow and encapsulation behaviour, which were provided by the EVA encapsulant layers on the outer layers of the sample.

### Comparative Example 2

A zeolite containing nanoclusters of Silver (Ag) was mixed into an EVA matrix at a concentration level of 6%. Two samples were produced. One sample was stored in a dry environment, controlled by a desiccant, while the second sample was stored at ambient conditions.

After 2 days the ambiently stored sample showed a slight discoloration, whereas the first sample, stored in a moisture controlled environment, did not show this effect. After 20 days the ambiently stored sample showed severe discoloration to brown, and lost transparency. The remaining transparency was lower than 10% in a wavelength range of 250 to 800 nm. The sample under controlled humidity showed only a small discoloration.

### Comparative Example 3

A further monolayer polymer sheet as in comparative example 2 was prepared, and laminated between two glasses using the same lamination cycle discussed in Example 1. The glass/glass sample was placed in a damp heat weathering chamber at 85°C and 85% relative humidity. A discoloration was visible at the edges of the glass plates after just 50 hours of damp heat testing.

### Comparative Example 4

Comparative Example 3 was repeated, however employing a glass/encapsulant/polymeric backsheet construction. The thus obtained element, and also placed in the weathering chamber. This sample turned quickly completely dark brown, illustrating the lower performance of the polymeric backsheet as moisture barrier as compared to the glass back plate of comparative example 4.

### Example 3

In order to keep the typical EVA encapsulation properties, a multilayer film was prepared comprising of two 200 µm thick EVA layers as outer layer and a thin middle layer consisting out of a polymer with better moisture barrier characteristics. The polymer that was chosen was a low density polyethylene. The melt index of the polyethylene was chosen is such a way that at the extrusion temperature of 110°C the melt flow was similar to the melt flow of EVA polymer at the same temperature. The Ag/zeolite powder was mixed in the polyethylene layer. The resulting film showed the characteristic encapsulation properties of a standard EVA monolayer, but also provided protection of the Ag/zeolite in the middle layer since it was embedded in a polymer with better moisture characteristics.

A glass/encapsulant multilayer /PEF backsheet element was prepared, which showed no significant discoloration after 500 h in the damp heat test.

### Example 4

A glass/multilayer/glass element was prepared, also applying an edge seal. This element showed no discoloration after 500 hours in the wet heat test. This construction keeps the largest portion of the moisture outside of the module, and it is expected that the multilayer polymer sheet will act as a second line of protection, and protect humidity ingress especially from moisture ingress via the junction box.

## Claims

1. Polymer sheet comprising multiple coextruded polymer layers, wherein at least one of these layers comprise a luminescence downshifting compound for at least partially absorbing radiation having a certain wavelength and re-emitting radiation at a longer wavelength than the wavelength of the absorbed radiation, and wherein the sheet comprises two outer polymer layers and at least one inner polymer layer, wherein an outer polymer layer or both outer polymer layers have a melting point T₁ which at least 10 °C below the melting point T₂ of at least one inner polymer layer, wherein the melting point T₁ is between 10 and 100 °C lower than the melting point T₂, and wherein the polymer sheet is obtained by co-extrusion of different polymer materials, which polymer materials are extruded at an extrusion temperature for each sub-layer so chosen that the largest difference in melt flow index (MFI) of the polymers of the sub-layers at the extrusion temperature as applied for each sub-layer is lower than 3 MFI points.

2. Polymer sheet according to claim 1, wherein two or more layers of the polymer sheet comprise a luminescence downshifting compound.

3. Polymer sheet according to claim 2, wherein the luminescence downshifting compound present in a first polymer layer, can absorb more radiation at a lower wavelength than the luminescence downshifting compound present in a next layer, optionally wherein the first polymer layer comprises a luminescence downshifting compound for at least partially absorbing UV radiation and re-emitting radiation at a higher wavelength

4. Polymer sheet according to any one of claims 1 to 3, wherein the one or more different luminescence downshifting compounds present in a first layer will absorb radiation at a lower wavelength than the one or more different luminescence downshifting compounds present in a next layer, wherein the two or more different luminescence downshifting compounds are chosen to form a cascade and wherein the cascade is defined in that a compound in the cascade reemits radiation in a wavelength range at which a next compound absorbs radiation.

5. Polymer sheet according to any one of claims 1 to 4, wherein a first polymer layer comprises a luminescence downshifting compound for absorbing radiation at between 280 to 400 nm and re-emitting radiation at between 400 to 550 nm, another polymer layer comprises a luminescence downshifting compound for absorbing radiation at between 360 to 470 nm and re-emitting radiation at between 410 to 670 nm, and another polymer layer comprises a luminescence downshifting compound for absorbing radiation at between 360 to 570 nm and re-emitting radiation at between 410 to 750 nm.

6. Polymer sheet according to any one of claims 1 to 5, wherein at least one of the polymer layers comprises ethylene vinyl acetate (EVA), ethylene vinyl alcohol (EVOH), polyvinylbutyral (PVB), polymethylmethacrylate(PMMA), alkylmethacrylate, alkylacrylate copolymers, polyurethanes, functionalized polyolefines, ionomers, thermoplastic polydimethylsiloxane copolymers, or mixtures thereof.

7. Polymer sheet according to any one of claims 1 to 6, wherein at least one of the polymer layers comprises an ethylene vinyl acetate polymer, preferably wherein the ethylene vinyl acetate has an acetate content of 12% up to 45% by weight.

8. Polymer sheet according to any one of claims 1 to 7, wherein at least one of the outer polymer layers comprises a silane coupling agent.

9. Polymer sheet according to claim 1, wherein the inner polymer layer comprises an optionally hydrogenated polystyrene block copolymer with butadiene, isoprene and/or butylenes/ethylene copolymers (SIS, SBS and/or SEBS); a ethylene vinyl alcohol (EVOH) copolymer, a polymethacrylate polyacrylate block copolymer, a polyolefin, a polyolefine copolymer or terpolymer, or an olefin copolymer or terpolymer, with copolymerizable functionalised monomers such as methacyrylic acid (ionomer).

10. Polymer sheet according to claim 5, wherein at least one of the outer layers comprises an ethylene vinyl acetate co-polymer, wherein the ethylene vinyl acetate has an acetate content of more than 18% by weight.

11. Element comprising two layers of glass, preferably a borosilicate glass or a soda lime glass, wherein a transparent polymer layer is present between the two layers of glass and wherein the polymer layer comprises a polymer sheet according to any one of claims 1 to 10.

12. Element according to claim 11, wherein the total thickness of the glass element is less than 5 mm.

13. Element according to claim 11, wherein at least one of the glass layers has a thickness of between 0.1 and 2 mm.

14. Element according to any one of claims 11 to 13, wherein at least one glass layer has a surface not facing the polymer layer which is covered with an anti-reflective coating.

15. Element according to any one of claims 11 to 14, wherein at least one glass layer has an embossed surface not facing the polymer layer.

16. Photovoltaic module comprising a layer comprising a photovoltaic cell and a cover layer comprising the element according to any one of claims 11 to 15.

17. CdTe photovoltaic solar cell comprising the glass element according to any one of claims 11 to 15, (a) a transparent electrode layer, (b) an n-type semiconductor layer, (c) a cadmium telluride absorber layer and (d) a back contact.

18. A solar panel comprising a polymer sheet according to any one of claims 1 to 10, and a photovoltaic cell, wherein the panel has a layer sequence of a glass layer, the polymer sheet, a photovoltaic cell, an encapsulant layer and a back sheet, preferably a glass layer.

19. Solar panel according to claim 18, wherein the glass layer facing the incoming radiation is provided with an anti-reflective coating.

20. Process to manufacture a solar panel by subjecting a stack comprising the following layers:
a glass layer (a),
a polymer sheet according to any one of claims 1 to 10 (b),
a layer (c) comprising a photovoltaic cell,
a polymer encapsulant layer (d); and
a glass layer (e),
to a thermal lamination at an elevated lamination temperature, wherein the polymer sheet (b) is comprised of 3 or more multiple coextruded thermoplastic polymer sub-layers comprising two outer sub-layers and at least one inner sub-layer, wherein the polymer sheet (b) is obtained by co-extrusion of different polymer materials which polymer materials are extruded at an extrusion temperature for each sub-layer so chosen that the largest difference in melt flow index of the polymers of the sub-layers at the extrusion temperature as applied for each sub-layer is lower than 3 MFI points, wherein the lamination temperature T_{L} is higher than the extrusion temperature Tc of an inner sub-layer; and wherein the temperature Tc is higher than the extrusion temperature T_{A} of an outer sub-layer and/or T_{B} of the other outer sub-layer.

21. Process according to claim20, wherein the lamination temperature is between 115 and 175 °C and wherein the environment of the stack has a pressure of less than 30 mBar.

## Patentansprüche

1. Polymerfolie, die mehrere koextrudierte Polymerschichten umfasst, wobei mindestens eine dieser Schichten eine lumineszenzsenkende Verbindung zum mindestens teilweisen Absorbieren von Strahlung, die eine bestimmte Wellenlänge aufweist, und Wiederausstrahlen von Strahlung bei einer längeren Wellenlänge als der Wellenlänge der absorbierten Strahlung umfasst, und wobei die Folie zwei äußere Polymerschichten und mindestens eine innere Polymerschicht umfasst, wobei eine äußere Polymerschicht oder beide äußeren Polymerschichten einen Schmelzpunkt T₁ aufweisen, der mindestens 10 °C unter dem Schmelzpunkt T₂ der mindestens einen inneren Polymerschicht liegt, wobei der Schmelzpunkt T₁ zwischen 10 und 100 °C niedriger ist als der Schmelzpunkt T₂, und wobei die Polymerfolie durch eine Koextrusion von verschiedenen Polymermaterialien erhalten wird, wobei die Polymermaterialien bei einer Extrusionstemperatur extrudiert werden, die für jede Teilschicht derart ausgewählt ist, dass der größte Unterschied in einem Schmelzflussindex (MFI) der Polymere der Teilschichten bei der Extrusionstemperatur, die für jede Teilschicht angewendet wird, niedriger ist als 3 MFI-Punkte.

2. Polymerfolie nach Anspruch 1, wobei zwei oder mehr Schichten der Polymerfolie eine lumineszenzsenkende Verbindung umfassen.

3. Polymerfolie nach Anspruch 2, wobei die lumineszenzsenkende Verbindung, die in einer ersten Polymerschicht vorhanden ist, mehr Strahlung bei einer niedrigeren Wellenlänge absorbieren kann als die lumineszenzsenkende Verbindung, die in einer nächsten Schicht vorhanden ist, gegebenenfalls wobei die erste Polymerschicht eine lumineszenzsenkende Verbindung zum mindestens teilweisen Absorbieren von UV-Strahlung und Wiederausstrahlen einer Strahlung bei einer höheren Wellenlänge umfasst.

4. Polymerfolie nach einem der Ansprüche 1 bis 3, wobei die eine oder mehreren verschiedenen lumineszenzsenkenden Verbindungen, die in einer ersten Schicht vorhanden sind, eine Strahlung bei einer niedrigeren Wellenlänge absorbieren als die eine oder mehreren verschiedenen lumineszenzsenkenden Verbindungen, die in einer nächsten Schicht vorhanden sind, wobei die zwei oder mehr verschiedenen lumineszenzsenkenden Verbindungen ausgewählt sind, um eine Kaskade zu bilden, und wobei die Kaskade dadurch definiert ist, dass eine Verbindung in der Kaskade eine Strahlung in einem Wellenlängenbereich wiederausstrahlt, bei dem die nächste Verbindung eine Strahlung absorbiert.

5. Polymerfolie nach einem der Ansprüche 1 bis 4, wobei eine erste Polymerschicht eine lumineszenzsenkende Verbindung zum Absorbieren von Strahlung zwischen 280 und 400 nm und Wiederausstrahlen von Strahlung bei zwischen 400 und 550 nm umfasst, eine weitere Polymerschicht eine lumineszenzsenkende Verbindung zum Absorbieren von Strahlung bei zwischen 360 und 470 nm und Wiederausstrahlen von Strahlung bei zwischen 410 und 670 nm umfasst und eine weitere Polymerschicht eine lumineszenzsenkende Verbindung zum Absorbieren von Strahlung bei zwischen 360 und 570 nm und Wiederausstrahlen von Strahlung bei zwischen 410 und 750 nm umfasst.

6. Polymerschicht nach einem der Ansprüche 1 bis 5, wobei mindestens eine der Polymerschichten Ethylenvinylacetat (EVA), Ethylenvinylalkohol (EVOH), Polyvinylbutyral (PVB), Polymethylmethacrylat (PMMA), Alkylmethacrylat, Alkylacrylat-Copolymere, Polyurethane, funktionalisierte Polyolefine, Ionomere, thermoplastische Polydimethylsiloxan-Copolymere oder Mischungen davon umfasst.

7. Polymerfolie nach einem der Ansprüche 1 bis 6, wobei mindestens eine der Polymerschichten ein Ethylenvinylacetat-Polymer umfasst, vorzugsweise wobei das Ethylenvinylacetat einen Acetatgehalt von 12 Gew.-% bis zu 45 Gew.-% aufweist.

8. Polymerfolie nach einem der Ansprüche 1 bis 7, wobei mindestens eine der äußeren Polymerschichten ein Silankupplungsmittel umfasst.

9. Polymerfolie nach Anspruch 1, wobei die innere Polymerschicht ein gegebenenfalls hydriertes Polystyrolblock-Copolymer mit Butadien, Isopren und/oder Butylen/EthylenCopolymeren (SIS, SBS und/oder SEBS); ein Ethylenvinylalkohol(EVOH)-Copolymer, ein Polymethacrylat-Polyacrylatblock-Copolymer, ein Polyolefin, ein Polyolefin-Copolymer oder - Terpolymer, oder ein Olefin-Copolymer oder -Terpolymer mit copolymerisierbaren funktionalisierten Monomeren wie Methacrylsäure (Ionomer) umfasst.

10. Polymerfolie nach Anspruch 5, wobei mindestens eine der äußeren Schichten ein Ethylenvinylacetat-Copolymer umfasst, wobei das Ethylenvinylacetat einen Acetatgehalt von mehr als 18 Gew.-% aufweist.

11. Element, das zwei Schichten von Glas, vorzugsweise ein Borsilikatglas oder ein Natronkalkglas umfasst, wobei eine transparente Polymerschicht zwischen den zwei Schichten von Glas vorhanden ist, und wobei die Polymerschicht eine Polymerfolie nach einem der Ansprüche 1 bis 10 umfasst.

12. Element nach Anspruch 11, wobei die Gesamtdicke des Glaselements weniger als 5 mm beträgt.

13. Element nach Anspruch 11, wobei mindestens eine der Glasschichten eine Dicke von zwischen 0,1 und 2 mm aufweist.

14. Element nach einem der Ansprüche 11 bis 13, wobei mindestens eine Glasschicht eine Fläche aufweist, die nicht der Polymerschicht zugewandt ist, und die mit einer antireflektierenden Beschichtung bedeckt ist.

15. Element nach einem der Ansprüche 11 bis 14, wobei mindestens eine Glasschicht eine geprägte Fläche aufweist, die nicht der Polymerschicht zugewandt ist.

16. Photovoltaikmodul, das eine Schicht, die eine Photovoltaikzelle umfasst, und eine Abdeckschicht, die das Element nach einem der Ansprüche 11 bis 15 umfasst, umfasst.

17. CdTe-Photovoltaik-Solarzelle, die das Glaselement nach einem der Ansprüche 11 bis 15, (a) eine transparente Elektrodenschicht, (b) eine Halbleiterschicht vom Typ n, (c) eine Kadmiumtellurid-Absorbtionsschicht und (d) einen Rückkontakt umfasst.

18. Solarpaneel, das eine Polymerfolie nach einem der Ansprüche 1 bis 10 und eine Photovoltaikzelle umfasst, wobei das Paneel eine Schichtenfolge von einer Glasschicht, der Polymerfolie, einer Photovoltaikzelle, einer Einkapselungsschicht und einer hinteren Lage, vorzugsweise einer Glasschicht aufweist.

19. Solarpaneel nach Anspruch 18, wobei die Glasschicht, die einer einfallenden Strahlung zugewandt ist, mit einer antireflektierenden Beschichtung bereitgestellt ist.

20. Verfahren zur Herstellung eines Solarpaneels durch ein Exponieren eines Stapels, der die folgenden Schichten umfasst:
eine Glasschicht (a), eine Polymerfolie nach einem der Ansprüche 1 bis 10 (b), eine Schicht (c), die eine Photovoltaikzelle umfasst, eine Polymer-Einkapselungsschicht (d); und eine Glasschicht (e), gegenüber einer thermischen Laminierung bei einer erhöhten Laminiertemperatur, wobei die Polymerfolie (b) aus 3 oder mehr mehrfach koextrudierten thermoplastischen Polymer-Teilschichten besteht, die zwei äußere Teilschichten und mindestens eine innere Teilschicht umfassen, wobei die Polymerfolie (b) durch eine Koextrusion von verschiedenen Polymermaterialien erhalten wird, wobei die Polymermaterialien bei einer Extrusionstemperatur extrudiert werden, die für jede Teilschicht derart gewählt ist, dass der größte Unterschied in einem Schmelzflussindex der Polymere der Teilschichten bei der Extrusionstemperatur, die für jede der Teilschichten angewendet wird, niedriger als 3 MFI-Punkte ist, wobei die Laminiertemperatur T_{L} höher ist als die Extrusionstemperatur Tc einer inneren Teilschicht; und
wobei die Temperatur Tc höher ist als die Extrusionstemperatur T_{A} einer äußeren Teilschicht und/oder T_{B} der anderen äußeren Teilschicht.

21. Verfahren nach Anspruch 20, wobei die Laminiertemperatur zwischen 115 und 175 °C beträgt, und wobei die Umgebung des Stapels einen Druck von weniger als 30 mbar aufweist.

## Revendications

1. Feuille de polymère comprenant des couches de polymère coextrudées multiples, dans laquelle au moins une de ces couches comprend un composé diminuant la luminescence destiné à absorber au moins partiellement un rayonnement ayant une certaine longueur d'onde et à réémettre le rayonnement à une longueur d'onde plus longue que la longueur d'onde du rayonnement absorbé, et dans laquelle la feuille comprend deux couches de polymère externes et au moins une couche de polymère interne, dans laquelle une couche de polymère externe ou les deux couches de polymère externes ont un point de fusion T₁ qui est au moins 10 °C au-dessous du point de fusion T₂ d'au moins une couche de polymère interne, dans laquelle le point de fusion T₁ est entre 10 et 100 °C plus bas que le point de fusion T₂, et dans laquelle la feuille de polymère est obtenue par coextrusion de matériaux polymères différents, lesquels matériaux polymères sont extrudés à une température d'extrusion pour chaque sous-couche choisie de telle sorte que la plus grande différence entre les indices de fluidité à chaud (IFC) des polymères des sous-couches à la température d'extrusion telle qu'elle est appliquée pour chaque sous-couche est inférieure à 3 points IFC.

2. Feuille de polymère selon la revendication 1, dans laquelle deux couches de la feuille de polymère ou plus comprennent un composé diminuant de luminescence.

3. Feuille de polymère selon la revendication 2, dans laquelle le composé diminuant la luminescence présent dans une première couche de polymère, peut absorber plus de rayonnement à une longueur d'onde plus basse, que le composé diminuant la luminescence présent dans une couche suivante, facultativement dans laquelle la première couche de polymère comprend un composé diminuant la luminescence destiné à absorber au moins partiellement le rayonnement UV et à réémettre le rayonnement à une longueur d'onde plus élevée.

4. Feuille de polymère selon l'une quelconque des revendications 1 à 3, dans lequel les un ou plusieurs composés diminuant la luminescence différents présents dans une première couche absorberont le rayonnement à une longueur d'onde plus basse que les un ou plusieurs composés diminuant la luminescence différents présents dans une couche suivante, dans laquelle les deux composés diminuant la luminescence différents ou plus sont choisis pour former une cascade et dans lequel la cascade est définie en ce qu'un composé dans la cascade réémet le rayonnement dans une plage de longueurs d'onde à laquelle un prochain composé absorbe le rayonnement.

5. Feuille de polymère selon l'une quelconque des revendications 1 à 4, dans laquelle une première couche de polymère comprend un composé diminuant la luminescence destiné à absorber un rayonnement à une longueur d'onde de 280 à 400 nm et à réémettre un rayonnement à une longueur d'onde de 400 à 550 nm, une autre couche de polymère comprend un composé diminuant la luminescence destiné à absorber le rayonnement à une longueur d'onde de 360 à 470 nm et à réémettre un rayonnement à une longueur d'onde de 410 à 670 nm, et une autre couche de polymère comprend un composé diminuant la luminescence destiné à absorber un rayonnement à une longueur d'onde de 360 à 570 nm et à réémettre un rayonnement à une longueur d'onde de 410 à 750 nm.

6. Feuille de polymère selon l'une quelconque des revendications 1 à 5, dans laquelle au moins une des couches de polymère comprend de l'éthylène-acétate de vinyle (EVA), de l'éthylène-alcool vinylique (EVOH), du poly(butyral vinylique) (PVB), du poly(méthacrylate de méthyle) (PMMA), du méthacrylate d'alkyle, des copolymères d'alkylacrylate, des polyuréthanes, des polyoléfines fonctionnalisées, des ionomères, des copolymères de polydiméthylsiloxane thermoplastiques, ou des mélanges de ceux-ci.

7. Feuille de polymère selon l'une quelconque des revendications 1 à 6, dans laquelle au moins une des couches de polymère comprend un polymère éthylène-acétate de vinyle, préférablement dans laquelle l'éthylène-acétate de vinyle a une teneur en acétate de 12 % à 45 % en poids.

8. Feuille de polymère selon l'une quelconque des revendications 1 à 7, dans laquelle au moins une des couches de polymère externes comprend un agent de couplage silane.

9. Feuille de polymère selon la revendication 1, dans laquelle la couche de polymère interne comprend un copolymère séquencé polystyrène facultativement hydrogéné, avec des copolymères butadiène, isopropène et/ou butylène/éthylène (SIS, SBS et/ou SEBS) ; un copolymère éthylène-alcool vinylique (EVOH), un copolymère séquencé poly(méthacrylate) poly(acrylate), une polyoléfine, un copolymère ou terpolymère polyoléfine, ou un copolymère ou terpolymère oléfine, avec des monomères fonctionnalisés capables de copolymérisation tels que l'acide méthacrylique (ionomère).

10. Feuille de polymère selon la revendication 5, dans laquelle au moins une des couches externes comprend un copolymère éthylène-acétate de vinyle, dans laquelle l'éthylène-acétate de vinyle a une teneur en acétate supérieure à 18 % en poids.

11. Élément comprenant deux couches de verre, préférablement un verre borosilicate ou un verre sodocalcique, dans lequel une couche de polymère transparente est présente entre les deux couches de verre et dans lequel la couche de polymère comprend une feuille de polymère selon l'une quelconque des revendications 1 à 10.

12. Élément selon la revendication 11, dans lequel l'épaisseur totale de l'élément de verre est inférieure à 5 mm.

13. Élément selon la revendication 11, dans lequel au moins une des couches de verre a une épaisseur comprise entre 0,1 et 2 mm.

14. Élément selon l'une quelconque des revendications 11 à 13, dans lequel au moins une couche de verre a une surface qui ne fait pas face à la couche de polymère qui est recouverte d'un revêtement antireflet.

15. Élément selon l'une quelconque des revendications 11 à 14, dans lequel au moins une couche de verre a une surface gaufrée qui ne fait pas face à la couche de polymère.

16. Module photovoltaïque comprenant une couche comprenant une cellule photovoltaïque et une couche de couverture comprenant l'élément selon l'une quelconque des revendications 11 à 15.

17. Cellule solaire photovoltaïque de CdTe comprenant l'élément de verre selon l'une quelconque des revendications 11 à 15, (a) une couche d'électrode transparente, (b) une couche de semi-conducteur de type N, (c) un couche d'absorption en tellurure de cadmium et (d) un contact arrière.

18. Panneau solaire comprenant une feuille de polymère selon l'une quelconque des revendications 1 à 10, et une cellule photovoltaïque, dans lequel le panneau a une séquence de couches d'une couche de verre, la feuille de polymère, une cellule photovoltaïque, une couche d'encapsulation et une feuille arrière, préférablement une couche de verre.

19. Panneau solaire selon la revendication 18, dans lequel la couche de verre faisant face au rayonnement entrant est pourvue d'un revêtement antireflet.

20. Procédé de fabrication d'un panneau solaire en soumettant un empilement comprenant les couches suivantes :
une couche de verre (a),
une feuille de polymère selon l'une quelconque des revendications 1 à 10 (b),
une couche (c) comprenant une cellule photovoltaïque,
une couche d'encapsulation de polymère (d) ; et
une couche de verre (e), à une stratification à une température de stratification élevée, dans lequel la feuille de polymère (b) est composée de 3 sous-couches de polymère thermoplastiques coextrudées multiples ou plus comprenant deux sous-couches externes et au moins une sous-couche interne, dans lequel la feuille de polymère (b) est obtenue par coextrusion de matériaux polymères différents, lesquels matériaux polymères sont extrudés à une température d'extrusion pour chaque sous-couche choisie de telle sorte que la plus grande différence entre les indices de fluidité à chaud des polymères des sous-couches à la température d'extrusion telle qu'elle est appliquée pour chaque sous-couche est inférieure à 3 points IFC, dans lequel la température de stratification T_{L} est supérieure à la température d'extrusion Tc d'une sous-couche interne ; et
dans lequel la température Tc est plus élevée que la température d'extrusion T_{A} d'une sous-couche externe et/ou T_{B} de l'autre sous-couche externe.

21. Procédé selon la revendication 20, dans lequel la température de stratification est entre 115 et 175 °C et dans lequel l'environnement de l'empilement a une pression inférieure à 30 mBar.
